Europäisches Patentamt

**European Patent Office**

Office européen des brevets

(11) Numéro de publication : **0 071 294
B1**

# (12) FASCICULE DE BREVET EUROPÉEN

(45) Date de publication du fascicule du brevet :
26.06.85

(51) Int. Cl.⁴ : **H 03 D   3/22, H 04 N   7/00**

(21) Numéro de dépôt : 82200909.8

(22) Date de dépôt : 16.07.82

(54) **Démodulateur de fréquence.**

(30) Priorité : 24.07.81 FR 8114453

(43) Date de publication de la demande :
09.02.83 Bulletin 83/06

(45) Mention de la délivrance du brevet :
26.06.85 Bulletin 85/26

(84) Etats contractants désignés :
**AT BE CH DE FR GB IT LI NL**

(56) Documents cités :
**FR-A- 1 421 674
FR-A- 2 265 216
FR-A- 2 324 161
W. CAUER: "Theorie der linearen Wechselstromschaltungen", vol. 1, 1941, pages 313-346, Akademische Verlagsgesellschaft Becker & Erler Kom.-Ges.,
Leipzig, DE.
PROCEEDINGS OF THE INSTITUTION OF ELECTRI-
CAL ENGINEERS, vol. 116, no. 1, janvier 1969, pages
53-58, London, G.B. L.J. STAG et al.: "Bandpass LC
filters having prescribed amplitude and nearly
constant group-delay characteristics"**

(73) Titulaire : **LA RADIOTECHNIQUE, Société Anonyme
dite:
51, rue Carnot BP 301
F-92156 Suresnes Cedex (FR)
FR
N.V. Philips' Gloeilampenfabrieken
Groenewoudseweg 1
NL-5621 BA Eindhoven (NL)
BE CH DE GB IT LI NL AT**

(72) Inventeur : **Hajj-Chehade, Mohammed
Société Civile S.P.I.D. 209 rue de l'Université
F-75007 (FR)**
Inventeur : **Lecat, Jean
Société Civile S.P.I.D. 209 rue de l'Université
F-75007 Paris (FR)**
Inventeur : **Tartois, Claude
Société Civile S.P.I.D. 209 rue de l'Université
F-75007 Paris (FR)**

(74) Mandataire : **Pinchon, Pierre et al
Société Civile S.P.I.D. 209 rue de L'Université
F-75007 Paris (FR)**

**Description**

L'invention concerne un démodulateur pour un signal modulé en fréquence, comportant un circuit multiplieur et un circuit de déphasage, une entrée du circuit multiplieur étant relié à une entrée du circuit de déphasage et une autre entrée du circuit multiplieur étant reliée directement à une sortie de ce même circuit de déphasage.

Des signaux modulés en fréquence sont utilisés fréquemment dans la transmission d'un son ou d'une image, en radiodiffusion et en télévision. Un problème particulier est posé en télévision parce que la bande passante est plus étendue qu'en radiodiffusion. En particulier dans le cas de la télévision transmise par un satellite, on utilise une porteuse image modulée en fréquence par la vidéofréquence, mais également modulée en fréquence par deux sous-porteuses de son dont les fréquences sont écartées de 5,5 et 5,75 MHz de celle de la porteuse image. La modulation en fréquence en question nécessite une bande passante utile de 27 MHz. La fréquence intermédiaire choisie étant de 134 MHz, la largeur de bande relative est de 27-134, soit 20 % (alors qu'en radiodiffusion, elle est d'environ 200 KHz pour 10,7 MHz, soit à peine 2 %). Quand la linéarité de la démodulation est insuffisante, des produits d'intermodulation apparaissent en particulier entre les deux sous-porteuses de son à 5,5 et 5,75 MHz. Ceci entraîne l'apparition, dans le spectre de la vidéofréquence démodulée, d'une raie à 250 KHz ainsi que d'autres raies parasites résultant du battement des deux sous-porteuses de son avec la sous-porteuse de chrominance du signal vidéofréquence, en produisant sur l'image des moirures très gênantes. Pour obtenir une qualité d'image satisfaisante, il est nécessaire que la non-linéarité soit inférieure à 0,4 % dans une bande passante relative d'au moins 16 %.

Un procédé de démodulation de fréquence connu consiste à effectuer le produit du signal à fréquence intermédiaire par ce même signal ayant traversé un circuit déphaseur. Ce procédé est décrit par exemple dans le brevet français FR-A-2 265 216. Ce document décrit un montage destiné au décodage de l'information de chrominance en système SECAM. Dans ce cas, seule la chrominance module une sous-porteuse et des battements ne sont pas à craindre entre deux sous-porteuses son modulant la même sous-porteuse, comme dans le cas expliqué plus haut. De plus les fréquences sont peu élevées et il est possible d'utiliser un déphaseur simple.

L'utilisation de ce montage dans l'application indiquée plus haut serait toutefois difficile et sa linéarité insuffisante, en l'absence de mesures particulières concernant le circuit déphaseur.

Pour de faibles largeurs de bande passante, un circuit déphaseur composé de deux bobines couplées avec éventuellement une bobine auxiliaire accordée sur la fréquence centrale et couplée à la deuxième bobine, donne une linéarité acceptable. Pour élargir la bande passante, il faut amortir les circuits oscillants, ce qui diminue la sensibilité du démodulateur et, malgré tout, on ne peut guère dépasser une largeur de bande relative de 5 % avec la linéarité souhaitée. De tels circuits donnent donc de très mauvais résultats dans l'application de télévision en question.

Un but de l'invention est de fournir un procédé de démodulation et un démodulateur qui procurent une très bonne linéarité dans une bande passante large, à des fréquences de plus de 100 MHz.

Un autre but de l'invention est de fournir un tel procédé et un tel démodulateur qui procurent une sensibilité élevée.

Un démodulateur selon l'invention est notamment remarquable en ce que le circuit de déphasage est constitué par au moins une cellule parmi une pluralité de cellules d'un filtre passe-bande en échelle et au plus un nombre de cellules inférieur au nombre total de cellules dudit filtre.

L'invention repose sur l'idée que certains filtres en échelle possédant un temps de retard de groupe faible et constant, ou à ondulation uniforme, peuvent être utilisés non pas en tant que filtres mais en tant que déphaseurs dans un tel montage de démodulation. Les réflexions au travers de la ou des cellules inutilisées permettent d'obtenir une amélioration de la courbe de déphasage dans la bande passante procurant une meilleure linéarité.

L'avantage de cette façon de faire est qu'elle permet d'obtenir une excellente linéarité de la démodulation dans une bande passante importante.

Avantageusement, on utilise un tel filtre passe-bande choisi dans la famille des filtres dits gaussiens. Cette famille est définie comme celle des filtres dont la réponse en impulsion est exempte de rebondissement et est symétrique par rapport à l'instant où la réponse est maximale. Pour qu'un filtre ait les propriétés qui viennent d'être définies en impulsion, il est nécessaire que sa réponse en phase soit linéaire, ce qui permet d'obtenir dans un démodulateur une linéarité excellente à condition que le multiplieur soit également linéaire.

De plus, le signal démodulé issu du multiplieur dépend de l'intégrale, c'est-à-dire de la différence de surface entre les arches positives et les arches négatives d'un signal plus ou moins carré. S'il y a des rebondissements, ceux-ci ne sont pas identiques pour les arches positives et pour les arches négatives puisque celles-ci n'ont pas toujours la même largeur, et ces rebondissements vont introduire des différences de surface imprévisibles entre les deux arches, d'où une dégradation de la linéarité de la démodulation. Selon un perfectionnement particulièrement intéressant, on utilise un filtre passe-bande gaussien du type à ondulation uniforme du temps de retard de groupe. Ceci présente l'avantage que l'on peut obtenir une bande passante utile plus large, avec le même nombre de cellules, en conservant une variation de phase, et donc une démodulation, quasi linéaire.

**0 071 294**

Une réalisation particulière comprend quatre cellules en échelle, et la sortie du signal déphasé se fait après la première cellule. Cette réalisation permet d'obtenir une bonne linéarité et son réglage est facile à effectuer.

Dans une forme de réalisation, une cellule du filtre comporte au moins un condensateur dans une branche série et une inductance en parallèle avec un condensateur dans une branche shunt. Cette configuration, qui est très simple, permet d'obtenir la courbe de déphasage désirée moyennant le choix de valeurs adéquates pour les composants.

La description qui va suivre, en regard des dessins annexés décrivant des exemples non limitatifs, fera bien comprendre comment l'invention peut être réalisée.

La figure 1 représente schématiquement un démodulateur selon l'invention.

La figure 2 illustre, au moyen de diagrammes la variation en fonction du temps de signaux qui apparaissent dans le démodulateur ci-dessus.

La figure 3 illustre la relation entre la fréquence et le déphasage apporté par un filtre de la famille des filtres dits gaussiens.

La figure 4 représente schématiquement la constitution d'un filtre utilisé dans un démodulateur selon l'invention.

La figure 5 représente le schéma d'un circuit multiplieur utilisé dans un démodulateur selon l'invention.

La figure 6 est une courbe illustrant la qualité des résultats obtenus par un démodulateur selon l'invention.

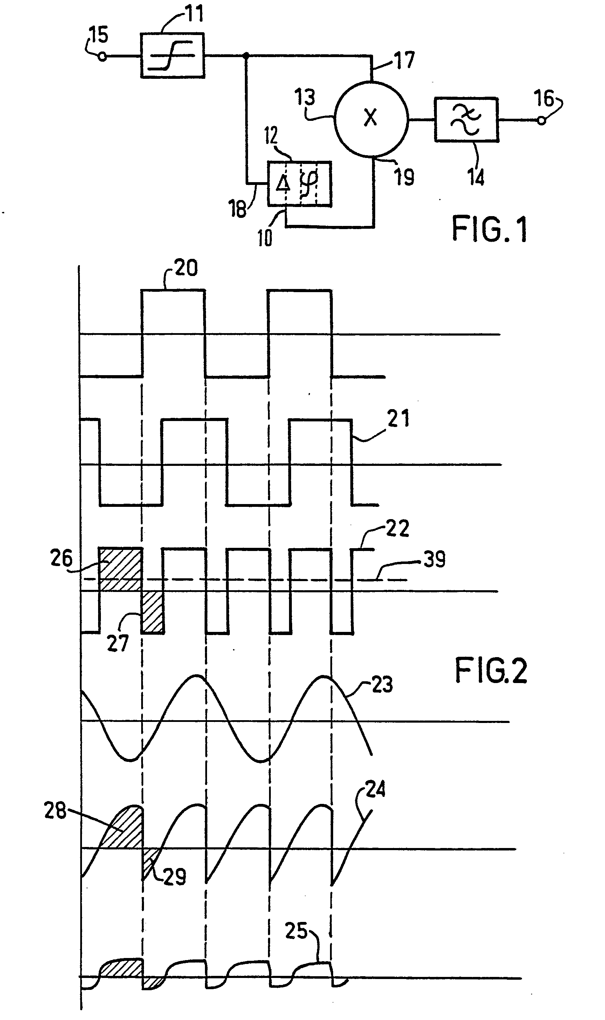

Selon la figure 1, un démodulateur selon l'invention comporte un circuit multiplicateur 13 et un circuit de déphasage 12 constitué par un filtre passe-bande en échelle. Une entrée 17 du circuit multiplieur est reliée à une entrée 18 du circuit de déphasage, et une autre entrée 19 du circuit multiplieur est reliée à une sortie 10 de ce même circuit de déphasage.

La démodulation d'un signal FM introduit sur la borne 15 est obtenue, ce signal étant limité en amplitude (écrêté) par le limiteur 11, en faisant passer ce signal par le circuit de déphasage 12 et en effectuant, au moyen du multiplicateur 13, le produit du signal présent à l'entrée 18 et du signal présent à la sortie 10 dudit circuit de déphasage. Le signal issu du multiplieur 13 est ensuite filtré dans un filtre passe-bas 14 et est disponible sur la borne 16. Le limiteur 11 et le filtre 14 sont bien connus de l'homme du métier.

La figure 2 illustre le fonctionnement du circuit 13 multiplieur. Les signaux référencés 21 ou 23 sont susceptibles d'être présents au point 10 du circuit de déphasage 12 et le signal référencé 20 à l'entrée 17 du circuit multiplicateur 13 et à l'entrée 18 du circuit déphaseur 12. Le multiplieur se comporte comme un permutateur commandé par le signal 20 : selon la polarité de ce signal 20, le signal 21 est transmis tel quel ou, au contraire, inversé. La sortie de ce circuit fournit donc le signal 22.

Le passage par un filtre passe-bas (représenté avec la référence 14 sur la figure 1), agissant comme un intégrateur, transforme le signal 22 en un signal 39 dont l'amplitude est proportionnelle à la différence des surfaces hachurées 26 et 27. Si le signal 22 est convenablement écrêté, ces surfaces sont proportionnelles à la largeur des créneaux et l'amplitude du signal 39 varie linéairement avec le déphasage entre les signaux 20 et 21 pour des valeurs de ce déphasage comprises entre 0 et $\pi$ radian. Avec un circuit déphaseur parfaitement linéaire en fonction de la fréquence du signal, une démodulation linéaire est possible. Le déphasage obtenu par les circuits couplés de l'art antérieur ne permet pas cette démodulation linéaire. Mais il existe des filtres passe-bande en échelle, qui sont habituellement employés pour le traitement des impulsions de radar, dont le temps de retard de groupe reste constant dans une certaine plage de fréquences, afin de ne pas déformer les impulsions. Or, un temps de retard de groupe constant implique un déphasage variant linéairement avec la fréquence.

Avec un tel filtre, les harmoniques des fréquences à démoduler sont atténués ou quasi supprimés et le signal sensiblement carré issu du limiteur devient presque sinusoïdal à la sortie du filtre, ainsi que représenté en 23. Si alors le signal issu du multiplieur était multiplié de façon parfaite par le signal 20, il aurait l'allure représentée en 24 et le signal intégré par le filtre passe-bas serait proportionnel à la différence des surfaces hachurées 28 et 29, et serait donc une fonction sinusoïdale du déphasage avec une valeur zéro pour un déphasage de $\pi/2$ radians, et des valeurs minimale et maximale pour un déphasage de, respectivement, 0 et $\pi$ radian. En pratique, le multiplieur représente des seuils de saturation et le signal qui en sort a, en réalité, l'allure indiquée en 25 plutôt que celle indiquée en 24. De ce fait, la variation de la tension de sortie du multiplieur en fonction du déphasage est intermédiaire entre celles produites par les signaux 21 et 23, et plutôt proche de celle produite par le signal 21. Il s'agit donc d'une variation linéaire légèrement déformée par une variation sinusoïdale.

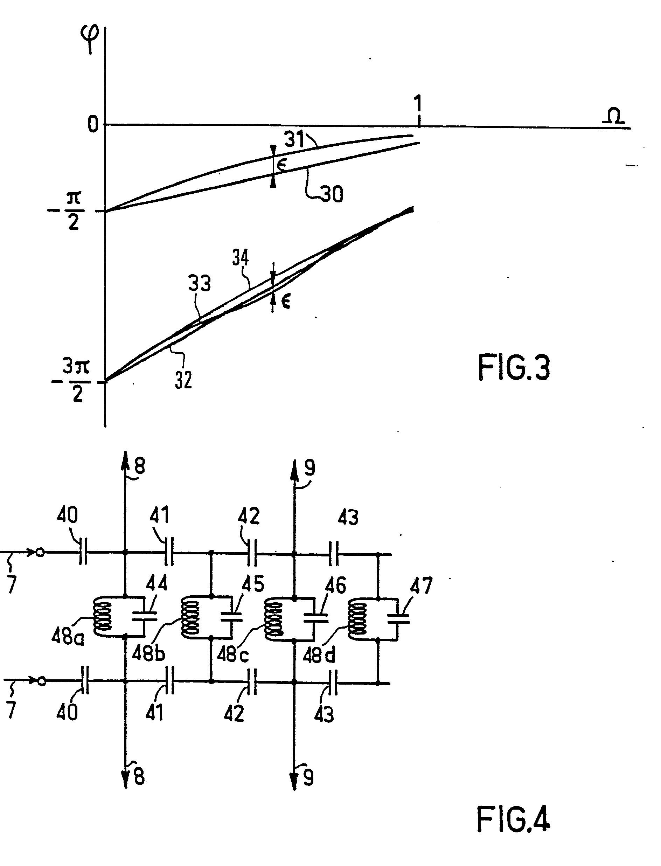

La figure 3 montre des courbes « phase-fréquence » d'un filtre passe-bande en échelle du type dit gaussien. La graduation horizontale représente $\Omega$ défini par :

$$\Omega = [(\omega/\omega_o) - (\omega_o/\omega)]/[(\omega_{B2}/\omega_o) - (\omega_{B1}/\omega_o)]$$

où $\omega$ est la pulsation du signal traité, $\omega_{B1}$ et $\omega_{B2}$ sont les pulsations des signaux pour une atténuation de 3 dB, à chaque extrémité de la bande passante, et $\omega_o$ est la moyenne géométrique de $\omega_{B1}$ et $\omega_{B2}$. Ce paramètre normalisé $\Omega$ vaut donc zéro $\omega = \omega_o$, 1 pour $\omega = \omega_{B2}$, et $-1$ pour $\omega = \omega_{B1}$. La courbe étant

3

symétrique autour de $\Omega = 0$, on n'a représenté que la moitié droite. La courbe 30 représente une variation idéalisée parfaitement linéaire dans le cas d'une cellule présentant un pôle. Mais un filtre ne peut être gaussien en théorie que pour un nombre infini de cellules : la courbe 31 montre la variation de phase réelle pour un filtre à une cellule. Sa convexité est tournée dans le bon sens pour compenser la composante sinusoïdale apportée par le multiplicateur, mais l'écart E avec la courbe 30 est excessif. Les courbes 32 et 33 représentent la même variation mais pour un filtre à trois cellules. La courbe 32 représente une variation idéale et la courbe 33 montre la variation réelle dans le cas particulier d'un filtre dit « à ondulation uniforme du temps de retard de groupe ». Par rapport à la courbe 32, cette courbe 33 présente un écart E qui change de signe. Cette courbe est plus proche de celle désirée que la courbe 31.

La courbe correspondant à un filtre dit « à temps de retard de groupe constant » (« maximally flat group delay » en langue française) ou filtre de Bessel est représentée en 34, elle ne présente pas de changement de signe de E mais la bande passante utile est alors moins large que pour la courbe 33 (cela n'apparaît pas sur la figure à cause de l'unité normalisée $\Omega$). Ces courbes peuvent être déduites des courbes normalisées de temps de retard de groupe présentées aux pages 93 et 95 de l'ouvrage « Handbook of filter synthesis » de Zverev édité par Wiley & Sons en 1967.

Comme il est indiqué ci-dessus, une courbe sensiblement linéaire ne peut être obtenue que par un grand nombre de cellules. On peut éviter la déformation sinusoïdale en sortie du multiplieur en fournissant à son entrée un signal carré, c'est-à-dire en ajoutant un amplificateur limiteur entre le déphaseur et le multiplieur. Le problème est donc résolu en employant un filtre à grand nombre de cellules et en ajoutant un amplificateur-limiteur parfait. Mais une telle solution est d'une grande complexité ! On a toutefois constaté qu'une courbe qui conduit à une très bonne correction sans ajouter d'amplificateur-limiteur est celle obtenue en prélevant le signal après la première cellule d'un filtre comportant trois ou quatre cellules. On obtient alors une courbe intermédiaire entre les courbes 30 et 31. L'emploi de quatre cellules plutôt que trois conduit à un réglage plus aisé, en permettant d'éviter des itérations dans le processus de réglage. Dans le cas où on emploie quatre cellules, on peut également prélever le signal après la troisième cellule et obtenir des résultats satisfaisants.

On utilise donc comme circuit de déphasage au moins une cellule parmi une pluralité de cellules d'un filtre passe-bande en échelle, et la sortie de ce circuit de déphasage est reliée directement au circuit multiplicateur. Par les mots « est reliée directement », on entend qu'il n'y a pas d'amplificateur-limiteur entre ces deux éléments. Un circuit de déphasage d'un démodulateur est ainsi constitué par au moins une cellule parmi une pluralité de cellules d'un filtre passe-bande en échelle, et la liaison entre la sortie de ce circuit de déphasage et l'entrée correspondante d'un circuit multiplieur est directe. Ledit filtre passe-bande est de la famille des filtres gaussiens, éventuellement avec une ondulation uniforme du temps de retard de groupe, afin d'élargir la bande passante dans laquelle le déphasage est presque linéaire. Un tel filtre présente une déformation légère compensant celle du multiplieur.

La figure 4 montre la structure d'un tel filtre en échelle. Il comporte ici quatre cellules, et la sortie du signal déphasé se fait sur les bornes 8 après la première cellule constituée des composants 40, 44, 48a. Elle peut aussi se faire sur les bornes 9 après les trois premières cellules. Le choix dépend de la forme d'onde à la sortie du limiteur 11 et du comportement du multiplieur.

Chaque cellule est constituée de deux circuits parallèles, constitués de condensateurs 40, 41, 42, 43 disposés en série, et d'une inductance 48 en parallèle avec un condensateur 44, 45, 46, 47, ce circuit LC étant branché en shunt entre les deux susdits circuits de condensateurs. Le nombre de cellules constituant le déphaseur, à savoir une ou trois cellules, est inférieur au nombre total de cellules du filtre (quatre cellules). On peut aussi, si le signal est prélevé en 8, supprimer les composants 43, 48d, 47, c'est-à-dire la quatrième cellule. Dans l'ouvrage cité ci-dessus de Zverev, on trouve page 97 un tableau de valeurs permettant de calculer les éléments du filtre. On a choisi pour ce calcul une erreur de phase de 0,5° et pour les inductances une surtension à vide de 70. Un jeu de valeurs conduisant à de bons résultats est le suivant :

inductances 48 : réglables autour de 200 nH
condensateur 40 : 2,7 pF
condensateur 41 : 6,8 pF
condensateur 42 : 3,9 pF
condensateur 43 : 2,7 pF
condensateur 44 : 3,3 pF
condensateur 45 : 2,2 pF
condensateur 46 : 3,3 pF
condensateur 47 : 4,7 pF
résistances d'amortissement : 1,5 k$\Omega$

Dans le cas où l'on prélève le signal sur les bornes 9, c'est à dire après la troisième cellule, les résistances d'amortissement doivent être augmentées et l'ajustage des inductances doit être modifié pour élargir légèrement la bande passante.

Au lieu de ramener à la masse les éléments shunt du déphaseur, on a préféré transposer en structure symétrique qui permet la connexion à des circuits actifs différentiels symétriques. Le multiplieur est du

4

type connu sous le nom de « multiplieur de Gilbert ». Un tel circuit est décrit ainsi que son utilisation en détecteur de phase dans l'ouvrage « Analysis & Design of Analog Integrated Circuits » de Gray et Meyer, édité en 1977 par Wiley & Sons, pages 563-566 et 570-575.

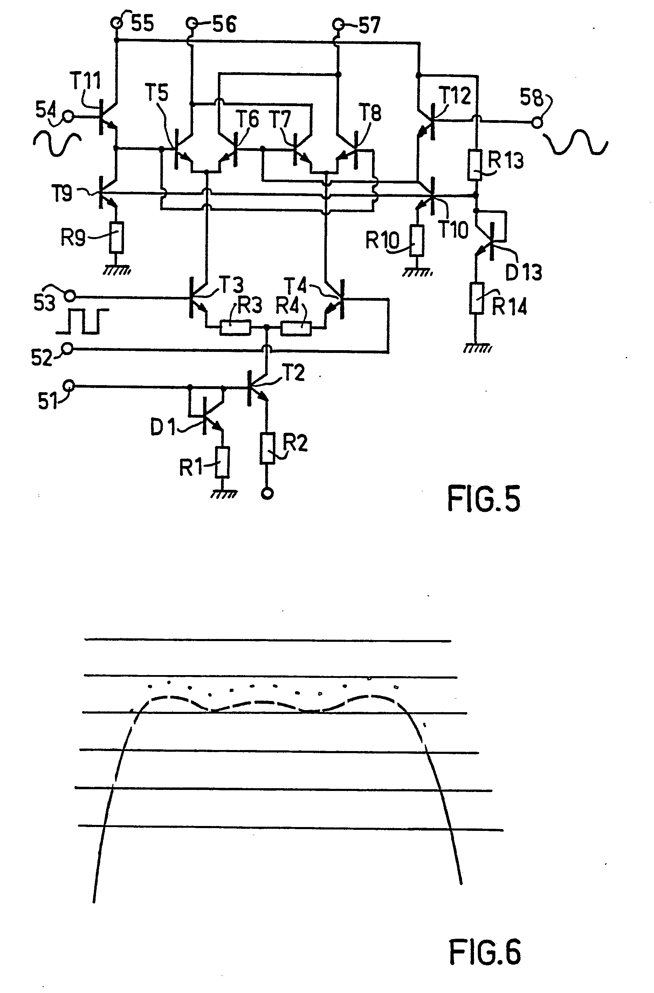

Une réalisation particulière est représentée par la figure 5. Les éléments constituant le cœur du multiplieur de Gilbert sont des transistors montés en paires différentielles T3-T4, T5-T6 et T7-T8. Les ensembles T9-R9 et T10-R10 constituent des sources de courant pilotées par le réseau résistif R13-R14 relié à la borne 55 d'alimentation en tension. La diode D13 a un rôle de stabilisation en température. Les transistors T11 et T12 montés en émetteurs suiveurs, chargés par les sources de courant T9 et T10, procurent une impédance d'entrée élevée pour les bornes d'entrée différentielles 54 et 58, auxquelles sont appliqués les signaux issus des bornes symétriques 8 (ou 9) de la figure 4. Aux bornes 52 et 53 sont appliqués, en même temps qu'aux bornes d'entrée 7 de la figure 4, les signaux symétriques issus du limiteur 11 de la figure 1. Des résistances R3 et R4 sont insérées dans les branches d'émetteur de T3 et T4. L'ensemble R1-R2-T2-D1 constitue une sortie de courant stabilisée en température lorsqu'on relie la borne 51 à une source de tension de référence.

Les valeurs des résistances sont :

R9, R10 :    100 ohms
R13 :    11 000 ohms
R14 :    200 ohms
R3, R4 :    50 ohms
R1, R2 :    150 ohms

L'ensemble est avantageusement réalisé en circuit intégré, par exemple dans la technologie dite « subilo » de la Société « R.T.C. LA RADIOTECHNIQUE-COMPELEC », avec une dimension uniforme de 3 micromètres pour les émetteurs des transistors.

La figure 6 montre les résultats obtenus. En ordonnées, sont représentés les écarts de linéarité, et en abscisse la fréquence. Les intervalles entre chacune des lignes horizontales représentent 1 % d'écart de linéarité, et les « marqueurs » hachurant la courbe sont écartés de 2 MHz. La zone dans laquelle l'ondulation de la courbe ne dépasse pas 0,4 % est d'environ 24 MHz, soit 18 % de bande passante relative. Le but recherché est donc bien atteint. Un réglage satisfaisant est obtenu en agissant tour à tour et dans l'ordre sur un noyau de réglage des inductances suivantes : 48a, 48d, 48a (à nouveau), 48b, 48c. Le réglage correct est obtenu très facilement. Bien entendu, d'autres formes de réalisation sont possibles et, en particulier, il existe des réseaux équivalents pour réaliser un même filtre avec des structures différentes, sans sortir du cadre de l'invention.

**Revendications**

1. Démodulateur pour un signal modulé en fréquence, comportant un circuit multiplieur (13) et un circuit de déphasage (12), une entrée (17) du circuit multiplieur étant reliée à une entrée du circuit de déphasage et une autre entrée (19) du circuit multiplieur étant reliée directement à une sortie de ce même circuit de déphasage, caractérisé en ce que le circuit de déphasage est constitué par au moins une cellule parmi une pluralité de cellules d'un filtre passe-bande en échelle et au plus un nombre de cellules inférieur au nombre total de cellules du filtre.

2. Démodulateur selon la revendication 1, caractérisé en ce que le filtre passe-bande est de la famille des filtres dits gaussiens.

3. Démodulateur selon la revendication 2, caractérisé en ce que le filtre passe-bande est du type à ondulation uniforme du temps de retard de groupe.

4. Démodulateur selon la revendication 1, caractérisé en ce que le filtre passe-bande comprend quatre cellules en échelle, et en ce que la sortie du signal déphasé se fait après la première cellule.

5. Démodulateur selon l'une quelconque des revendications 1 à 4, caractérisé en ce que chaque cellule du filtre comporte au moins un condensateur (40) dans une branche série, et une inductance en parallèle avec un condensateur (48a, 44) dans une branche shunt.

**Claims**

1. An FM-demodulator, comprising a multiplier circuit (13) and a phase shifting circuit (12), an input (11) of the multiplier circuit being connected to an input of the phase shifting network, a further input (19) of the multiplier circuit being connected directly to an output of this phase shifting circuit, characterized in that the phase shifting circuit is constituted by at least one section from a plurality of sections of a bandpass-ladder filter and at most a number of sections which is less than the total number of sections of said filter.

2. A demodulator as claimed in Claim 1, characterized in that the bandpass filter is of the Gaussian filter type.

3. A demodulator as claimed in Claim 2, characterized in that the bandpass filter is of the type having a uniform waveform of the group delay time.

4. A demodulator as claimed in Claim 1, characterized in that the bandpass filter comprises four ladder sections, and that the output of the phase-shifted signal is located behind the first section.

5. A demodulator as claimed in any one of the Claims 1 to 4, characterized in that each filter section comprises at least a capacitor (40) in a series branch and an inductance which is in parallel with a capacitor (48a, 44) in a shunt branch.

**Patentansprüche**

1. Demodulator für ein frequenzmoduliertes Signal mit einer Multiplizierschaltung (13) und einem Phasenschieber (12), wobei ein Eingang (17) der Multiplizierschaltung mit einem Eingang des Phasenschiebers verbunden ist und ein anderer Eingang (19) der Multiplizierschaltung unmittelbar mit einem Ausgang desselben Phasenschiebers verbunden ist, dadurch gekennzeichnet, dass der Phasenschieber mindestens eine Zelle einer Vielzahl von Zellen eines Durchlasskettenfilters aufweist und höchstens eine Anzahl Zellen, die kleiner ist als die Gesamtanzahl Zellen des Filters.

2. Demodulator nach Anspruch 1, dadurch gekennzeichnet, dass das Bandpassfilter vom Gauss-Filtertyp ist.

3. Demodulator nach Anspruch 2, dadurch gekennzeichnet, dass das Durchlassfilter von dem Typ mit einer einheitlichen Wellenform der Gruppenlaufzeit ist.

4. Demodulator nach Anspruch 1, dadurch gekennzeichnet, dass das Durchlassfilter vier Leiterzellen aufweist und dass der Ausgang des phasengedrehten Signals sich hinter der ersten Zelle befindet.

5. Demodulator nach einem der Ansprüche 1-4, dadurch gekennzeichnet, dass jede Zelle des Filters mindestens einen Kondensator (40) einem Längszweig aufweist und eine Induktivität parallel zu einem Kondensator (48a, 44) in einem Querzweig.

FIG.1

FIG.2

FIG.3

FIG.4

FIG.5

FIG.6

3